# EUROPEAN PATENT APPLICATION

(11) **EP 1 160 356 A1**
(43) Date of publication of application: **05.12.2001**
(21) Application number: 00985822.6
(22) Date of filing: 21.12.2000
(51) Int. Cl.: C23C 18/40, H01L 21/3205

(54) **ELECTROLESS PLATING SOLUTION AND METHOD OF FORMING WIRING WITH THE SAME**

(30) Priority: 22.12.1999 JP 36546499
(71) Applicant: EBARA CORPORATION, Ohta-ku, Tokyo 144-8510 (JP); KABUSHIKI KAISHA TOSHIBA, Kawasaki-shi, Kanagawa-ken 210-8520 (JP)
(72) Inventor: INOUE, Hiroaki, Machida-shi, Tokyo 194-0041 (JP); MISHIMA, Koji, Fujisawa-shi, Kanagawa 251-0016 (JP); NAKAMURA, Kenji, Fujisawa-shi, Kanagawa 251-0045 (JP); OKUYAMA, Shuichi, Nyuropoto-Nakamachidairyou, Yokohama-shi, Kanagawa 24-0041 (JP); MATSUDA, Tetsuo, Tano-gun, Gunma 370-2101 (JP); KANEKO, Hisashi, Fujisawa-shi, Kanagawa 251-0043 (JP)
(74) Representative: Wagner, Karl H., Dipl.-Ing.
(86) International application number: JP0009099
(87) International publication number: WO0146494

(57) **Abstract**

The present invention provides an electroless plating liquid which allows a plating rate to be controlled, is not largely influential on semiconductor characteristics, and poses no problem on the health of workers, and a method of forming an interconnection according to a electroless plating process which uses such an electroless plating liquid. The electroless copper plating liquid contains dihydric copper ions, a complexing agent, an aldehyde acid, and an organic alkali. The electroless copper plating liquid is preferably be used in a method having the steps of forming an auxiliary seed layer for reinforcing a copper seed layer in an interconnection groove defined in a surface of a semiconductor device, and performing an electrolytic plating process using the seed layer including the auxiliary seed layer as a current feeding layer, for thereby filling copper in the interconnection groove defined in the surface of the semiconductor device.

## Description

### Technical Field

The present invention relates to an electroless plating liquid and a method of forming an interconnection using such an electroless plating liquid, and more particularly to an electroless plating liquid for filling interconnection recesses defined in a semiconductor substrate with an interconnection forming metal such as copper, its alloy, or the like, and a method of forming an interconnection using such an electroless plating liquid.

### Background Art

For forming interconnection ' circuits on semiconductor substrates, it has heretofore been customary to grow an aluminum or aluminum alloy film on a substrate surface according to sputtering or the like, and then remove unwanted portions from the film according to chemical dry etching using a pattern mask such as a resist. However, as the level of circuit integration increases, the width of interconnections decreases and the current density in the interconnections increases, causing thermal stresses and temperature rises. Therefore, the interconnections are liable to break due to stress migration or electromigration.

Copper which is lower in resistance and higher in reliability than aluminum or aluminum alloy has been drawing attention as a promising interconnection material. However, it is difficult to grow, pattern, and etch a copper film into interconnections as is the case with the conventional aluminum interconnections. In view of the difficulty, it has been attempted to perform a damascene interconnection process for producing a groove interconnection by defining an interconnection groove in a substrate surface, filling copper in the interconnection groove according to chemical vapor deposition (CVD), sputtering, or plating, and thereafter removing excess copper from the substrate surface according to chemical mechanical polishing (CMP) or the like.

Of the above filling processes, the plating process is attracting attention because it is less costly than the other processes, is able to produce a copper material of high purity, and is a low-temperature process which causes less damage to the substrate. Plating processes include an electroless plating process which is mainly a chemical process, and an electrolytic plating process which is an electrochemical process. Generally, the electrolytic plating process is more efficient and allows a plating rate to be controlled with ease, but requires more complex facilities and operation steps.

A barrier layer made of a metal nitride such as TiN, TaN, WN or the like usually needs to be provided between the substrate and the interconnection for preventing the copper or the like from being diffused. The barrier layer has a sheet resistance value which is much greater than the resistance value of the copper. A copper seed layer is grown on the barrier layer by sputtering or CVD, and an electrolytic copper plating process is carried out using the copper seed layer as an electrode. However, the sputtering process is problematic in that it fails to grown copper uniformly on the walls of minute recesses, and the CVD process is disadvantageous in that the grown copper film contains impurities. If the design rule is reduced from 0.18 µm to 0.10 µm, then no dimensional margins are available for forming a copper seed layer having a thickness in the range from 0.02 to 0.05 µm in recesses.

According to the conventional electroless plating process, since a plated layer grows isotropically from the side walls and bottom of minute recesses, the metal grown from the side walls covers the inlets of the recesses, tending to form voids in the substrate surface. For adjusting the pH of the electroless plating liquid, a solution (e.g., NaOH) containing alkaline metal ions such as Na⁺, K⁺, or the like is used. EDTA·4Na or the like is used as a complexing agent. Thus, the alkaline metal is introduced into the plated copper film, degrading the semiconductor characteristics.

The plating rate of the electroless plating process cannot easily be controlled. It is difficult to form a uniform thin film of copper whose thickness ranges from 0.02 to 0.05 µm in the recesses whose size is reduced from 0.18 µm to 0.10 µm. If the plating rate is too large, the. recesses are filled with copper irregularly, tending to form voids.

As a consequence, the management of the plating process is highly difficult to perform. According to the electroless plating process, the time in which the substrate contacts the plating liquid is the plating time. Therefore, if the plating rate is high and if the plating liquid remains on the semiconductor substrate or wafer in other times of operation of the plating apparatus, e.g., the times for delivering the semiconductor wafer and discharging the plating liquid from the plating tank, then the plating process continues in those other times.

According to the conventional electroless copper plating process, HCHO (formaldehyde) is used as a reducing agent, and its carcinogenic nature is dangerous to the health of workers involved in the electroless copper plating process.

In the conventional electroless plating process, endocrine disruptors such as polyoxyethylene alkylphenylether phosphoric acid and/or polyoxyethylene alkylphenylether (e.g., RE610 manufactured by Toho Chemical Industry Co., Ltd.), indicated below, are used as an additive for the purposes of stabilizing the plating liquid and controlling the plating rate, and these materials tend to cause the problem of environmental pollution.

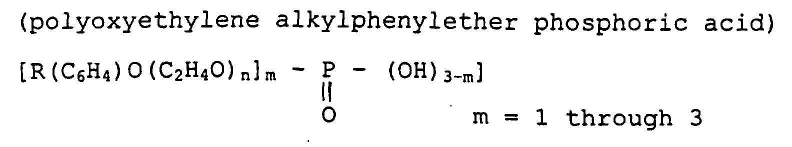

(polyoxyethylene alkylphenylether) R(C₆H₄)O(C₂H₄O)ₙH

### Disclosure of Invention

It is an object of the present invention to provide an electroless plating liquid which allows a plating rate to be controlled, is not largely influential on semiconductor characteristics, and poses no problem on the health of workers, and a method of forming an interconnection according to a electroless plating process which uses such an electroless plating liquid.

To achieve the above object, there is provided in accordance with the present invention an electroless copper plating liquid for forming a thin film copper interconnection for a semiconductor device having a filled interconnection structure, characterized by containing dihydric copper ions, a complexing agent, an aldehyde acid, and an organic alkali.

The electroless copper plating liquid should preferably further contain polyoxyethylene alkylphenylether phosphoric acid, polyoxyethylene alkylphenylether, and a mixture of polyoxyethylene alkylphenylether phosphoric acid and polyoxyethylene alkylphenylether (e.g., RT610 manufactured by Toho Chemical Industry Co., Ltd.) at a concentration ranging from 1 to 100 mg/L.

Preferably, the complexing agent comprises EDTA·4H (ethylenediaminetetraacetic acid), the aldehyde acid comprises a glyoxylic acid, and the organic alkali comprises TMAH (tetramethylammonium hydroxide).

Since the complexing agent comprises EDTA·4H containing no alkaline metals and TMAH which is the organic alkali containing no alkaline metals is used for pH adjustment, alkaline metals are prevented from being introduced into a plated copper film, and hence the semiconductor characteristics are prevented from being degraded.

If a reducing agent of glyoxylic acid is used, a healthy working environment is maintained.

Since the electroless copper plating liquid contains polyoxyethylene alkylphenylether phosphoric acid, polyoxyethylene alkylphenylether, and a mixture of polyoxyethylene alkylphenylether phosphoric acid and polyoxyethylene alkylphenylether, the plating rate is made lower than the plating rate of the conventional plating process, allowing the thickness of the plated film to be controlled with ease. Specifically, when the plating rate is lowered, a time margin is achieved in the plating process to provide freedom for the design of the plating process and apparatus. This advantage manifests itself particularly in the formation of thin films. While the plating rate for such an application is usually 100 nm/min. or lower, the plating rate may be reduced to 50 nm/min. or lower. Inasmuch as the lower plating rate gives good film thickness controllability, the electroless copper plating liquid is suitable for use in forming copper interconnections on semiconductor substrates.

Compounds added to the electroless copper plating liquid according to the present invention are not endocrine disruptors, and do not disturb the ecosystem.

Preferably, the dihydric copper ions have a concentration ranging from 0.01 to 10.0 g/L, the EDTA·4H has a concentration ranging from 0.5 to 100 g/L, the glyoxylic acid has a concentration ranging from 1 through 50 g/L, and the electroless copper plating liquid has a pH adjusted to a range from 10 to 14 by the TMAH.

A method of forming a copper interconnection on a semiconductor device according to the present invention is characterized by the steps of forming an auxiliary seed layer for reinforcing a copper seed layer in an interconnection groove defined in a surface of the semiconductor device using an electroless copper plating liquid containing dihydric copper ions, a complexing agent, an aldehyde acid, and an organic alkali, and performing an electrolytic plating process using the seed layer including the auxiliary seed layer as a current feeding layer, for thereby filling copper in the interconnection groove defined in the surface of the semiconductor device.

Because the auxiliary seed layer for reinforcing the copper seed layer on the barrier layer can be formed at a low plating rate with a simple apparatus and process arrangement, the process management is facilitated. Furthermore, the auxiliary seed layer is formed in a wet environment which is the same as the subsequent electrolytic plating process, cleaning and drying steps may be dispensed with, and a delivery process between the steps may be simplified. The method makes it easy to construct a good working environment which will cause no damage to the health of workers and the natural environment on the earth.

According to the present invention, there is also provided a method of forming a copper interconnection on a semiconductor device, characterized by plating copper on a surface of a semiconductor substrate in an electroless copper plating process at a plating rate of 50 nm/min, or less, using an electroless copper plating liquid containing dihydric copper ions, a complexing agent, an aldehyde acid, and an organic alkali.

### Brief Description of Drawings

FIG. 1 is a graph showing the results of a test of measuring a composition distribution along the depth of alkaline metals in a plated film which is produced using an electroless plating liquid according to the present invention;
FIG. 2 is a graph showing the results of a test of measuring a composition distribution along the depth of alkaline metals in a plated film which is produced using a conventional electroless plating liquid; and
FIG. 3 is a graph showing plating rates achieved using the electroless plating liquid according to the present invention and the conventional electroless plating liquid.

### Best Mode for Carrying Out the Invention

An embodiment of the present invention will be described below with reference to the drawings.

The present invention resides in a method of forming a copper interconnection on a semiconductor device by plating a surface of a semiconductor substrate with copper using an electroless copper plating liquid which contains dihydric copper ions, a complexing agent, an aldehyde acid, and an organic alkali.

The electroless copper plating liquid according to the embodiment of the present invention and a plating liquid according to a comparative example were prepared, and a silicon wafer or substrate having a barrier layer (TaN, 20 nm) and a seed layer (copper, 20 nm) formed thereon by sputtering was plated using those plating liquids.

As shown in Table 1 below, the electroless copper plating liquid according to the embodiment of the present invention contains 5 g/L of CuSO₄·5H₂O which supplies dihydric copper ions, 14 g/L of EDTA·4H as a complexing agent, 18 g/L of glyoxylic acid as an aldehyde acid which serves as a reducing agent, and TMAH as an organic alkali for adjusting the pH to 12.5. The electroless copper plating liquid according to the embodiment of the present invention also contains a mixture of polyoxyethylene alkylether phosphoric acid and polyoxyethylene alkylether (e.g., RT610 manufactured by Toho Chemical Industry Co., Ltd.). The conventional electroless plating liquid contains 14 g/L of EDTA·4Na as a complexing agent, 5 ml/L of HCHO as a reducing agent, NaOH as an alkali for adjusting the pH to 12.5, and α, α'-dipyridyl. The plating temperature for both plating liquids is 60°C.

**[Table 1]**

| (Plating liquid composition) | | |
|---|---|---|
| | Inventive plating liquid | Conventional plating liquid |
| CuSO₄·5H₂O (g/l) | 5 | 5 |
| EDTA·4H (g/l) | 14 | - |
| EDTA·4Na (g/l) | - | 14 |
| Glyoxylic acid (g/l) | 18 | - |
| HCHO(37%) (ml/l) | - | 5 |
| TMAH (-) | pH adjusted to 12.5 | - |
| NaOH (-) | - | pH adjusted to 12.5 |
| Additive (-) | 5 mg/L of RT610 added | 5 mg/L of α, α'-dipyridyl added |

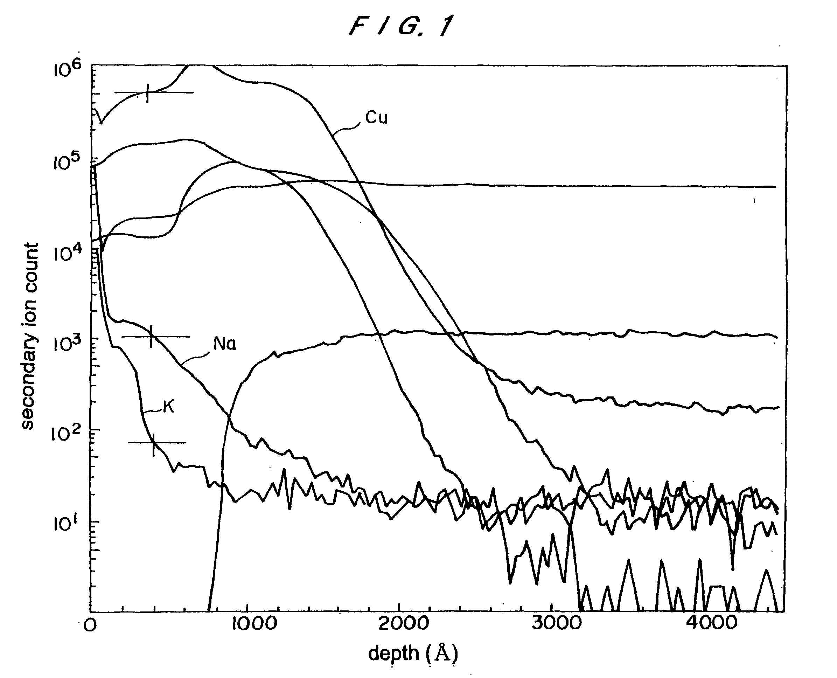

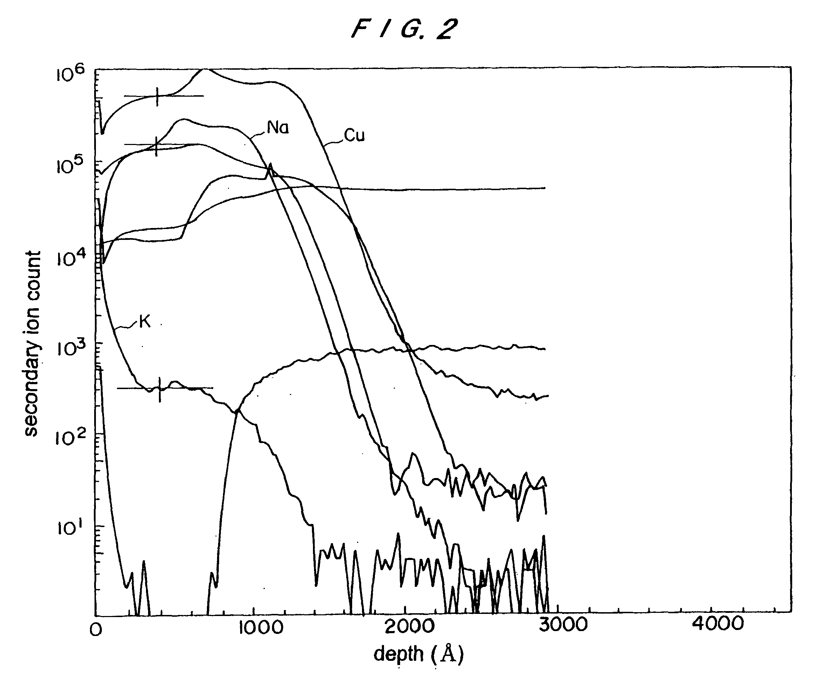

FIGS. 1 and 2 show respective distributions along the depth of alkaline metals including Na, K, etc. in the plated films formed using the above plating liquids. The distributions were measured using SIMS (secondary ion mass spectrometer. It can be seen from FIGS. 1 and 2 that the amounts of Na, K contained in the plated film formed using the plating liquid according to the present invention are smaller than the amounts of Na, K contained in the plated film formed using the conventional plating liquid.

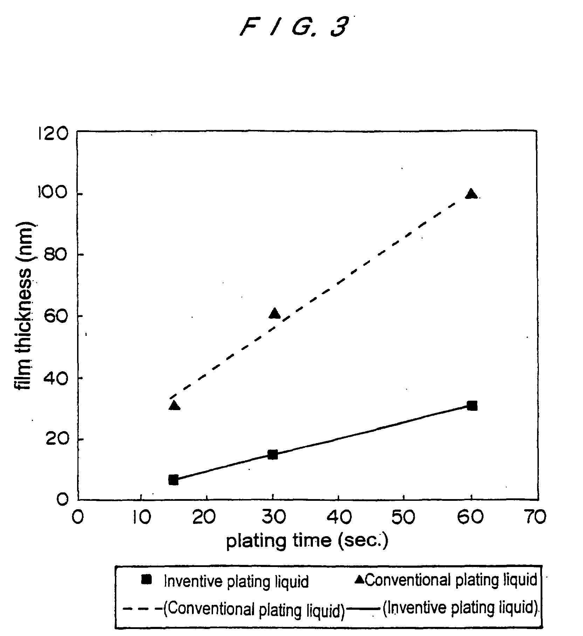

Table 2 and FIG. 3 show plating rates achieved using the plating liquid according to the present invention and the conventional plating liquid. The plating rate achieved using the plating liquid according to the present invention is about one-quarter of the plating rate achieved using the conventional plating liquid. The plating liquid according to the present invention allows a plated film to be formed at a plating rate of 30 nm/min. Therefore, the plating liquid according to the present invention makes it easy to form a reinforcing seed layer having a thickness of 20 nm in a minute groove defined in a surface of a semiconductor substrate. According to the present invention, the method of forming a copper interconnection on a semiconductor device can perform an electroless copper plating process at a plating rate of 50 nm/min. or less.

**[Table 2]**

| (Comparison of plating rates) | | |
|---|---|---|
| Plating time (sec.) | Film thickness achieved using inventive plating liquid (nm) | Film thickness achieved using conventional plating liquid (nm) |
| 15 | 7.1 | 31.2 |
| 30 | 15 | 60.5 |
| 60 | 31.2 | 100 |

(Remark) The plating specimens are spCu20nm/TaN20nm/Si wafers.

Since the plating rate can be lowered in the electroless plating liquid according to the present invention, the plating liquid may preferably be used to form a seed layer for electrolytic plating on the barrier layer. However, the electroless plating liquid according to the present invention may be used to form an interconnection according to the electroless plating process only. In this case, the present invention also offers an advantage in that the plating process can easily be managed.

Because the electroless copper plating liquid according to the present invention employs a pH adjustor with no alkali metal content, the electroless copper plating liquid makes it possible to produce a thin film copper interconnection for semiconductor devices which has a filled interconnection structure having reduced alkaline metal impurities in the plated film.

Since the pH adjustor does not contain alkali metals, EDTA·4H is used as a complexing agent, and glyoxylic acid is used as a reducing agent, the plating process can be performed in a clean room in a semiconductor fabrication plant.

Moreover, inasmuch as the plating rate can be lowered, the plated film thickness can easily be controlled, making it possible to produce a thin film copper interconnection for semiconductor devices which has a filled interconnection structure. The plating liquid according to the present invention is suitable for forming a seed electrode layer for electrolytic plating.

### Industrial Applicability

The present invention can preferably be used in applications for forming copper interconnections in minute grooves defined in surfaces of semiconductor substrates.

## Claims

1. An electroless copper plating liquid for forming a thin film copper interconnection for a semiconductor device having a filled interconnection structure, **characterized by** containing dihydric copper ions, a complexing agent, an aldehyde acid, and an organic alkali.

2. An electroless copper plating liquid according to claim 1, **characterized by** further containing polyoxyethylene alkylphenylether phosphoric acid and/or polyoxyethylene alkylphenylether, which has the structure indicated below, at a concentration ranging from 1 to 100 mg/L: 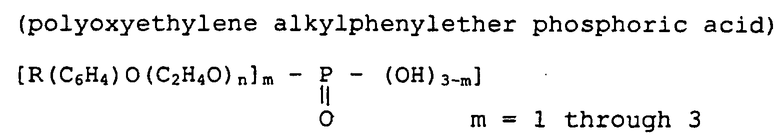
(polyoxyethylene alkylphenylether) R (C₆H₄) O (C₂H₄O)ₙH

3. An electroless copper plating liquid according to claim 1, **characterized in that** said complexing agent comprises EDTA·4H (ethylenediaminetetraacetic acid), said aldehyde acid comprises a glyoxylic acid, and said organic alkali comprises TMAH (tetramethylammonium hydroxide).

4. An electroless copper plating liquid according to claim 4, **characterized in that** said copper ions have a concentration ranging from 0.01 to 10.0 g/L, said EDTA·4H has a concentration ranging from 0.5 to 100 g/L, said glyoxylic acid has a concentration ranging from 1 through 50 g/L, and the electroless copper plating liquid has a pH adjusted to a range from 10 to 14 by said TMAH.

5. A method of forming a copper interconnection on a semiconductor device, **characterized by** the steps of forming an auxiliary seed layer for reinforcing a copper seed layer in an interconnection groove defined in a surface of the semiconductor device using an electroless copper plating liquid containing dihydric copper ions, a complexing agent, an aldehyde acid, and an organic alkali, and performing an electrolytic plating process using the seed layer including said auxiliary seed layer as a current feeding layer, for thereby filling copper in the interconnection groove defined in the surface of the semiconductor device.

6. A method of forming a copper interconnection according to claim 5, **characterized by** performing an electroless copper plating process at a plating rate of 50 nm/min. or less using said electroless copper plating liquid.

7. A method of forming a copper interconnection according to claim 5, **characterized in that** said electroless copper plating liquid contains polyoxyethylene alkylphenylether phosphoric acid and/or polyoxyethylene alkylphenylether, which has the structure indicated below, at a concentration ranging from 1 to 100 mg/L: 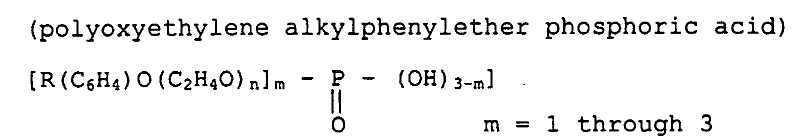
(polyoxyethylene alkylphenylether) R (C₆H₄) O (C₂H₄O)ₙH

8. A method of forming a copper interconnection according to claim 5, **characterized in that** said complexing agent comprises EDTA·4H (ethylenediaminetetraacetic acid), said aldehyde acid comprises a glyoxylic acid, and said organic alkali comprises TMAH (tetramethylammonium hydroxide).

9. A method of forming a copper interconnection according to claim 8, **characterized in that** said copper ions have a concentration ranging from 0.01 to 10.0 g/L, said EDTA·4H has a concentration ranging from 0.5 to 100 g/L, said glyoxylic acid has a concentration ranging from 1 through 50 g/L, and the electroless copper plating liquid has a pH adjusted to a range from 10 to 14 by said TMAH.

10. A method of forming a copper interconnection on a semiconductor device, **characterized by** performing an electroless copper plating process at a plating rate of 50 nm/min. or less using said electroless copper plating liquid.

11. A method of forming a copper interconnection on a semiconductor device, **characterized by** plating copper on a surface of a semiconductor substrate using an electroless copper plating liquid containing dihydric copper ions, a complexing agent, an aldehyde acid, and an organic alkali.

12. A method of forming a copper interconnection according to claim 11, **characterized by** performing an electroless copper plating process at a plating rate of 50 nm/min. or less.
